# EUROPEAN PATENT SPECIFICATION

(11) **EP 2 417 469 B1**
(45) Date of publication and mention of the grant of the patent: **26.03.2014**
(21) Application number: 10715624.2
(22) Date of filing: 06.04.2010
(51) Int. Cl.: G01R 33/28, F17C 13/00, G01R 33/62

(54) **APPARATUS AND METHOD FOR INTRODUCTION OF A MATERIAL INTO A CRYOGENIC SYSTEM**
VORRICHTUNG UND VERFAHREN ZUR EINFÜHRUNG EINES MATERIALS IN EIN KRYOGENES SYSTEM
DISPOSITIF ET PROCÉDÉ D'INTRODUCTION D'UNE MATIÈRE DANS UN SYSTÈME CRYOGÉNIQUE

(30) Priority: 06.04.2009 US 418649
(43) Date of publication of application: 15.02.2012
(73) Proprietor: General Electric Company, Schenectady, NY 12345 (US)
(72) Inventor: LEACH, Andrew Michael, Clifton Park New York 12065 (US); TRIGGER, James, Richard, Rotterdam Junction New York 12150 (US); URBAHN, John, Arthur, Saratoga Springs New York 12866 (US)
(74) Representative: Bedford, Grant Richard
(86) International application number: PCT/US2010/030044
(87) International publication number: WO 2010/117983

(56) References cited:
- US-A- 5 611 207
- US-A1- 2008 242 974
- WOLBER J ET AL: "Generating highly polarized nuclear spins in solution using dynamic nuclear polarization" NUCLEAR INSTRUMENTS & METHODS IN PHYSICS RESEARCH, SECTION - A:ACCELERATORS, SPECTROMETERS, DETECTORS AND ASSOCIATED EQUIPMENT, ELSEVIER, AMSTERDAM, NL LNKD- DOI:10.1016/J.NIMA.2004.03.171, vol. 526, no. 1-2, 21 June 2004 (2004-06-21), pages 173-181, XP004830097 ISSN: 0168-9002

## Description

### BACKGROUND

Dynamic nuclear polarization (DNP) is a technique that generates an excess of one nuclear spin relative to the other orientation. This excess can be on the order of several thousand-fold at cryogenic temperatures and several hundred thousand-fold at room temperature. This increase in population of one nuclear spin relative to the other is seen as an increase in the signal-to-noise ratio of measurements in nuclear magnetic resonance (NMR) systems such as magnetic resonance imagers (MRI).

To achieve high levels of polarization via DNP, materials or samples must be cooled to extremely low temperatures, often less than four Kelvin and optimally in the range of one Kelvin. These low temperatures are typically achieved by reducing the pressure above a volume of liquid helium. As the pressure above the helium bath is reduced the temperature of the bath is reduced as defined by the saturation curve of liquid helium. The introduction of warm samples into this environment can significantly impact the temperature of the helium bath as well as the polarization of any samples that are already present in the bath. Additionally, the process of cooling samples results in the vaporization of liquid helium from the helium bath, impacting the duration the helium bath can be maintained and the number of samples that can be processed.

A conventional means of reducing the pressure above a helium bath is the use of one or more mechanical pumps. These pumps expel helium into the ambient environment as a result of this pumping process, making it difficult and expensive to reuse the cryogen. The quantity of helium in this bath can be either static, being filled before the pumping is initiated, or dynamic through the use of a second helium reservoir connected to the pumped region via a regulated passageway such as a needle valve. The static system often exhibits a limited operational period due to size constraints of the helium bath. The dynamic system, although more flexible, contains mechanical components within the cryogenic environment, potentially limiting the robustness of the device.

A sorption pump may be used in a closed cycle cryogenic system that is designed to generate one-Kelvin temperatures without loosing cryogen (liquid helium) volume. This sorption pump contains a charcoal-based sorbent that absorbs gaseous helium at low temperatures, thus acting as a means to reduce the pressure above a volume of liquid helium. When the temperature of the charcoal is elevated the gaseous helium is released from the sorption pump, thus acting as a source of helium for the liquid helium bath. This sorption pump may be operated in a cyclic fashion that first condenses liquid helium and then reabsorbs the helium while generating reduced temperatures. In this cyclic manner of operation the total volume of cryogen remains constant. The fact that this system operates without losing cryogen volume is a significant benefit to ease of operation by eliminating the need for frequent cryogen transfers as well as a cost savings through the elimination of cryogen purchases.

However, a limitation of this system is that during the condensation portion of the sorption pump cycle, the volume of liquid helium generated is limited by several geometric considerations including the mass of charcoal, the amount of gaseous helium loaded into the charcoal and the physical size of the container into which the helium is condensed. Because of this limited volume of liquid helium the amount of heat directed to the helium bath directly impacts the amount of material or number of samples that can be cooled and polarized during one thermal cycle.

US 2008/0242974 describes a method and apparatus for hyperpolarizing materials for MR including a sorption pump. In particular, this US patent application discloses an apparatus in accordance with the preamble of claim 1.

### BRIEF DESCRIPTION

The present invention overcomes the aforementioned drawbacks by providing an apparatus and method as defined by the appended claims for introducing material into a cryogenic system with minimal impact to the thermal performance of the system by directing heat from the introduced material away from the liquid helium bath and to a cooling unit.

### BRIEF DESCRIPTION OF THE DRAWINGS

The drawings illustrate an embodiment presently contemplated for carrying out the invention.
FIG. 1 is a schematic illustration of the sample path within the cryogenics system.
FIG. 2 is a thermal profile of the cryogenic helium bath and cooling unit using the unidirectional sample loading procedure.
FIG. 3 is a thermal profile of the cryogenic helium bath and cooling unit using the bidirectional sample loading procedure.

### DETAILED DESCRIPTION OF THE PREFERRED EMBODIMENT

The following detailed description is exemplary and not intended to limit the invention of the application and uses of the invention. Furthermore, there is no intention to be limited by any theory presented in the preceding background of the invention or the following detailed description of the drawings.

Provided herein are methods and apparatus for the introduction of a sample into a cryogenic system from ambient temperatures. Cryogenic systems are often used in medical imaging, power generation and scientific research applications. Cryogenic systems are also used in apparatuses for hyperpolarization of samples and are described in co-owned U.S. Patent Application No US 2008/0240998 A1.

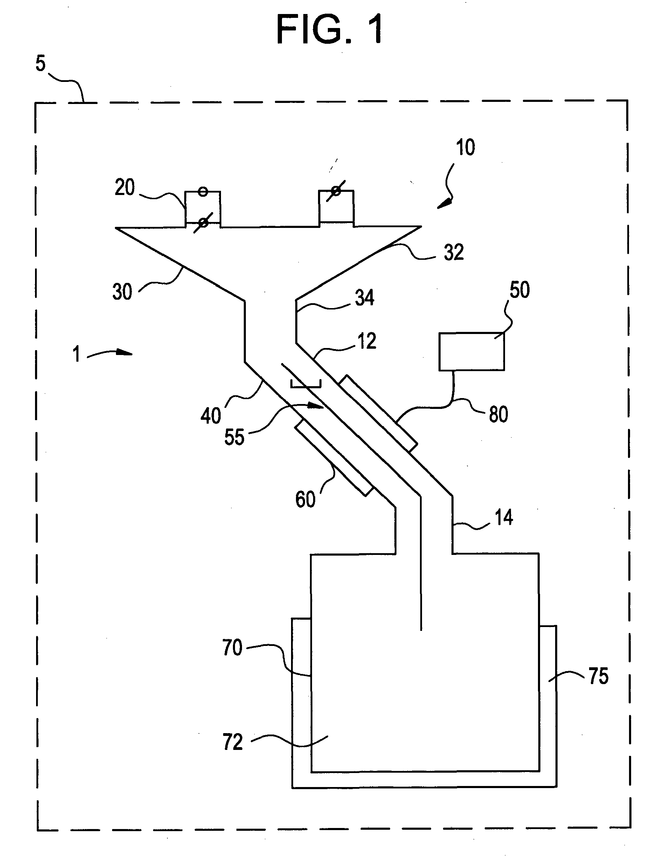

Referring now to FIG. 1, in one embodiment of the present invention, an apparatus 1 for introducing a material into a cryogenic system 70 from ambient temperature through an elongate sample path 10 is provided. Apparatus 1 is desirably incorporated into a dynamic nuclear polarization hyperpolarization system, represented by phantom line 5. The sample path 10 extends in fluid communication with an airlock chamber 20 on one end and a cryogenic chamber 70 on the other end and is thermally linked to a cooling unit 50. The dimension and geometry of the sample 10 path may vary based on the application. The sample path 10 may consist of a series of separate segments. In one embodiment, the sample path may comprise a first and second thin walled tube, 12 and 14, located at opposing ends of an equilibrator 60. The equilibrator 60 is a tubular structure comprised of a high thermally conductive material, such as copper, and is thermally linked to cooling unit 50. The two thin walled tubes 12 and 14 may be comprised of a low thermally conductive material such as steel. The tubes 12 and 14 may also be corrugated to reduce the conductive thermal loads. To minimize radiative heating, the sample path may be configured to geometrically offset tubes 12 and 14 at opposing end of the sample path 10 such that there is no direct line of sight from the entrance of the first tube 12 to the exit of the second tube 14. Such an offset can be established by fixing the two tubes 12 and 14 parallel to one another but laterally offset with the equilibrator 60. The diameters of the tubes 12 and 14 may be minimized to restrict heat loads, but be of sufficient diameter to allow samples to pass through.

As shown in FIG.1, apparatus 1 allow materials to be introduced from ambient temperature and pressure into a cryogenic system 70 through a sample path 10. This passage consists of an airlock 20 that allows for samples to move from ambient pressure into the lower pressure environment of the cryogenic system, a funnel 30 that directs multiple samples into a common path in order to reduce heat loads to the system, and an elongate tube 40 that extends between the funnel 30 and the cryogenic helium bath 72. Funnel 30 includes a conical region 32 in fluid communication with the airlock chamber 20 and a narrowed region 34 in fluid communication with the first tubes 12. While tube 40 is shown to include first and second tubes 12 and 14, the present invention contemplates that tube 40 be formed with a single tube extending through equilibrator 60. A section of the sample path 10 thus functions as an equilibrator 60 and is constructed of a material with a high thermal conductivity, such as copper. The equilibrator 60 is thermally linked to a cooling unit 50, which typically operation at temperatures less than 10 Kelvin. The equilibrator 60 and the cooling unit 50 allow samples, introduced at ambient conditions, to equilibrate with the cryogenic system 70 before introducing the samples into the cryogenic helium bath 72. The cooling unit 50 may be a refrigeration unit, such as a stored liquid or solid cryogen cooling system, or a continuous flow cryostat. The cooling unit 50 is connected to the equilibrator 60 by a thermal refrigeration link 80. The refrigeration link 80 may be comprised of a high thermally conductive material, such as copper. In certain embodiment the refrigeration link 80 may be braided copper.

If multiple samples are to be admitted to the cryogenic helium bath 72, a common path may be used. Such a common path may use funnel 30 at the entrance of the first steel tube 12 to direct multiple samples to the cryogenic helium bath 72. An example of a sample path 10 is two 19.1 mm (0.750-inch) inner diameter corrugated tubes connected to a 19.1 mm (0.750-inch) inner diameter copper tube. The first corrugated steel tube 12 is attached to a funnel 30 that enables the simultaneous direction of four or more samples to the helium bath 72. The samples are 3.18 mm (0.125-inch) outer diameter tubes with 12.7 mm (0.500-inch) outer diameter bulbs located at the distal tips. The sample path inner diameter is large enough to simultaneously accommodate one sample bulb and three sample tubes. This configuration dictates that although four samples can be present in the helium bath 72 simultaneously, only one sample can be moved though the 19.1 mm (0.750-inch) inner diameter sample path at a given point in time. The cooling unit 50 employed in this arrangement may be a two stage Sumitomo SRDK-415D cryogenic cooling system. In other embodiments, the cooling unit 50 may be a cryogen cooling system operating at a temperature of approximately four Kelvin such as any Gifford-McMahon (GM) type cyrocooler.

One or more samples may be initially loaded into the airlock 20 where the surrounding air is removed and replaced with a cryogenic gas such as helium. The pressure in this airlock is reduced to more closely match the pressure within the cryogenic system 70. A dynamic seal or baffle may be used to maintain pressure. At least one sample is lowered from the airlock chamber 20 into the proximal end of the sample path 10, and directed to the equilibrator 60. The sample is positioned within the equilibrator 60 where contact with the highly conductive material of the equilibrator 60 allows for conduction of heat from the sample to the cooling unit.

Imperfections in the surface of the sample and the equilibrator 60 may limit the amount of heat transferred via conduction, thus convective cooling may also be used to transfer heat from the sample to the equilibrator 60. To generate an environment suitable for convection, a limited quantity of heat may be directed to the cryogenic helium bath 72 resulting in a modest increase in pressure within the sample path 10.

In one embodiment, the cryogenic bath 72 contains liquid helium. The magnitude of this pressure increase is directly related to the temperature of the liquid helium and thus this pressure increase is typically small in order to not impact the processing of other samples, which may reside in the bath. Pressures of 5.5 Pa (0.055 millibar) and 9.6 Pa (0.096 millibar) can be achieved within the sample path while only increasing the helium bath's temperature to 0.90 and 0.95 Kelvin, respectively, based on the liquid helium saturated vapor pressure relationship. In practice it is desirable to maintain this pressure below 10 Pa (0.1 millibar). However, this maximum temperature excursion is balanced by the need for rapid sample introduction. Higher pressures and thus temperatures will enhance heat flow from the warm sample to the cryogenic refrigerator, thus enabling the acceleration of sample introduction, but at the cost of increase temperature fluctuations within the cryogenic helium bath 72.

Convective cooling may be utilized by introducing a sample in to the system and positioning the sample below the equilibrator 60 in successive steps, where each step brings the samples closer to the cryogenic helium bath 70. After each repositioning of the sample a time delay allows helium gas, collected in the sample path space during the repositioning process, to transfer heat from the sample to the equilibrator 60 via convection. The values for this sample introduction procedure include three five-centimeter movements (5, 10 and 15 cm below the equilibrator) with five-minute delays between movements. The number, location and duration of repositioning steps may be empirically determined and adjusted based on operating conditions and geometry of the system.

A positioning system 55 may be used to position samples within this sample path 10 in a manner that would control conductive and convective heat transfer from samples to the equilibrator 60. The positioning system may be manual motion based on graduated markings on a sample delivery device. Alternatively, robotic systems with feedback control may be used to precisely control the location of the sample within the sample path. Such a robotic system may be fabricated from pitch wheels that drive a sample delivery device into the sample path. The pitch wheels may further provide feedback regarding sample positioning through the use of an idler wheel that measures sample slippage.

After the final repositioning step the sample may be introduced into the cryogenic helium bath 72 with minimal impact on the helium bath temperature. This method provides a method for thermal conditioning of samples, by controlling the distance between the sample and the equilibrator during successive steps, which limits the transfer of heat to the equilibrator while simultaneously allowing for heat transfer to be directed to the cryogenic helium bath.

According to the invention, the sample may be positioned below the equilibrator 60, i.e, between equilibrator 60 and cryogenic helium bath 70, for brief durations to increase pressure within the sample path 10 due to collection of helium gas, and then returned to the equilibrator 60 to allow for enhanced transfer of heat from the sample to the equilibrator rather than the cryogenic helium bath 72. To generate this increase in pressure within the sample path the sample may be lowered to successively lower positions before returning to the equilibrator for heat transfer. For example, a sample introduction procedure may include six steps where the sample is successively positioned 3.75, 5.00, 5.56, 5.63, 5.75 and 10.00 cm below the equilibrator for five seconds before returning to the equilibrator for delays of two minutes to allow for heat transfer. The number, location and duration of these steps may be determined empirically and may be changed based on the geometry and conditions.

An advantage of using successive steps in lowering and repositioning a sample may be that the sample related heat loads are predominately directed to a cooling unit rather than the liquid volume of the cryogenic bath. The impact on the temperature of the cryogenic liquid volume resulting from the introduction of samples is minimized.

In another example which is not an embodiment of the invention, one allows a modest increase in gas pressure of the cryogenic bath coolant within the sample path during equilibration steps. This increase in pressure can be achieved through introduction of a warm sample in the headspace above the cryogenic helium bath 72. A combination of conductive, convective, and radiative heating from the warm sample to the cooled helium bath 72 will result in a local increase in pressure and thus an increase in convective heat transfer to the surrounding environment. A portion of the convective heat will be directed to the highly conductive portion of the sample path 10 and transferred to the cooling unit 50 via the thermal linkage 80. The magnitude of the pressure increase and the proximity of the warm sample relative to this highly conductive section of the sample path 10 will dictate the percentage of heat directed to the cooling unit 50 relative to the cryogenic helium bath 72. The heat flow to the cooling unit 50 may be increased by repositioning the warm sample within the equilibrator region of the sample path 10 following the increase in pressure. This process may be repeated until the sample is sufficiently cooled to introduce the sample to the cryogenic helium bath 72 with minimal impact of the bath's characteristics.

Alternatively, a separate heat source 75 local to the cryogenic helium bath 72 may be used to increase the pressure within the sample path. Although this approach would reduce the need for repositioning of the sample to generate the pressure increase, this approach may introduce an additional heat source into the system thus potentially impacting other system characteristics including helium bath temperature of service life.

By employing successive steps, the impact of the sample loading related heat on the volume of cryogenic liquid in the cryogenic helium bath may be minimized. This may increase the maximum number of samples that can be processed during one cycle of a sorption pump in a cryogenic system be increased. The combination of convective and conductive cooling may also allow rapid cooling of samples without the need for physical movement of mechanical parts within the cryogenic system, such as equilibrator components that apply pressure to the sample to enhance conduction.

In one embodiment, a machine-readable medium comprising instructions which when executed by a controller coupled to the cryogenic system may be used. The machine-readable medium may control the loading of samples, position of the sample in the sample path, and provide a means for monitoring and controlling temperature and pressure within the cryogenic system.

### EXAMPLES

Methods on operating the equilibrator 60 were developed by repetitively introducing samples into the cryogenic system and measuring the temperature of the cryogenic helium bath 72 as well as the volume of liquid helium consumed. Cryogenic helium bath temperature was monitored with ruthenium oxide temperature sensors located on the helium bath container. The volume of liquid helium consumed per sample was calculated by (1) determining the duration a known quantity of liquid helium would remain in the cryogenic vessel of the bath 72 as a result of parasitic heat loads and (2) the decrease in this duration as a result of introducing a known number of samples.

### Example 1: Unidirectional Sample Loading Procedure

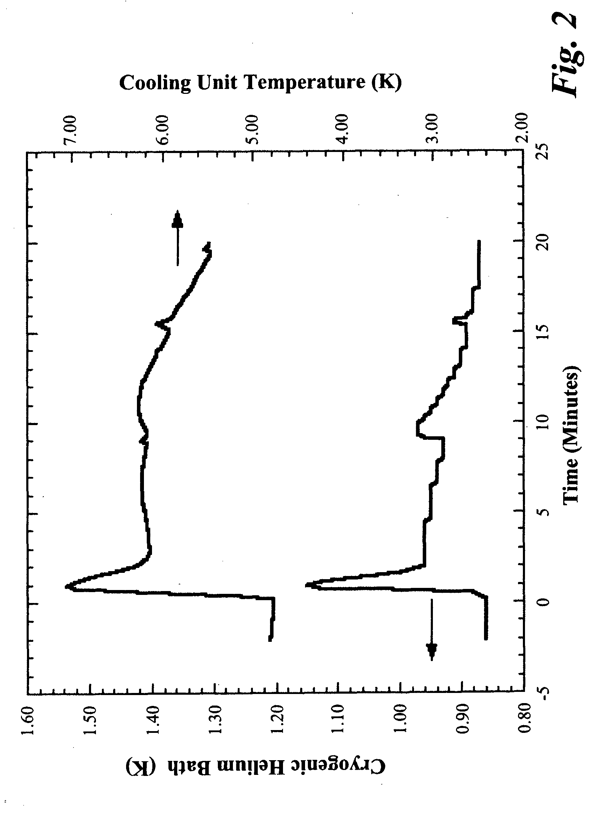

A 2.0 g sample of glycerol was pre-cooled to 77 K prior to introduction into the airlock 20 of a cryogenic system incorporating apparatus 1. The temperature of this sample increases during the loading process but the exact temperature of the sample prior to movement into the sample path 10 is unknown. The sample was lowered to the equilibrator 60 where it was allowed to remain for six minutes. Next, the sample was lowered to a position five centimeters below the equilibrator 60 and allowed to remain for six minutes. The sample was then positioned 10 centimeters below the equilibrator 60 and allowed to remain for six minutes. Finally the sample was inserted into the cryogenic helium bath 72. An example of the temperature of the cryogenic helium bath 72 and the temperature of the cooling unit 50 during sample loading is shown in FIG. 2.

### Example 2: Bidirectional Sample Loading Procedure (in accordance with the invention(

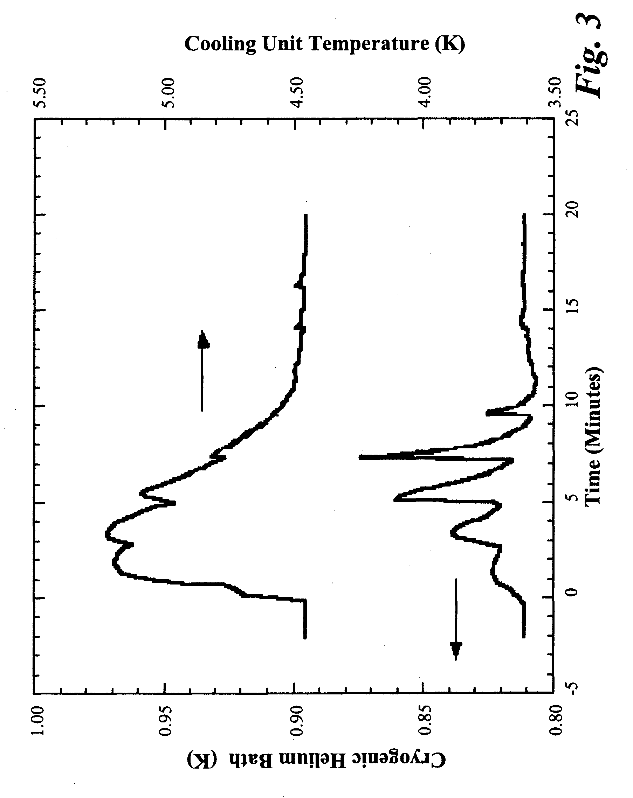

A 0.8 g sample of pyruvic acid was warmed to room temperature (nominally 293 K) prior to introduction into a cryogenic system incorporating apparatus 1. The sample was lower to the equilibrator 60 where it remained for three minutes. The sample was then lowered to 3.75 cm below the equilibrator 60 where it remained for five seconds before returning to the equilibrator 60 where it remained for two minutes. This procedure of lowering and raising of the sample to and from equilibrator 60 was repeated to depths of 5.00, 5.56, 5.63, and 5.75 cm below the equilibrator in successive steps. The sample was then lowered to 10 cm below the equilibrator 60 where it was allowed to remain for two minutes. Finally the sample was inserted into the cryogenic helium bath 72. An example of the temperature of the cryogenic helium bath 72 and the temperature of the cooling unit 50 during sample loading is shown in FIG.3. Using this method approximately 4% of the samples heat was directed to the cryogenic helium bath corresponding to 22 cc/sample of helium consumed.

The foregoing embodiments are to be considered in all respects as illustrative rather than limiting on the invention described herein. The scope of the invention is thus indicated by the appended claims rather than by the foregoing description, and all changes that come within the meaning and range of equivalency of the claims are therefore intended to be embraced therein.

## Claims

1. An apparatus (1) for introducing a sample into a cryogenic system (70) comprising:
an airlock chamber (20);
a cryogenic helium bath (72); and
a sample path (10) extending between a first end connected in fluid communication to the airlock chamber and a second end connected in fluid communication to the cryogenic helium bath;
wherein the sample path (10) further comprises:
an equilibrator (60) positioned between the airlock and the cryogenic helium bath, the equilibrator allowing for passage of a sample to the cryogenic helium bath, and
a cooling unit (50) coupled to the equilibrator (60) to control the temperature of the equilibrator (60);
**characterized in that** the apparatus (1) is arranged to lower the sample from the equilibrator (60) into the helium bath (72) in successive steps, wherein each step reduces the distance between the sample in the sample path (10) and the cryogenic helium bath (72), and to retract the sample into the equilibrator (60) after each successive step to allow for enhanced transfer of heat from the sample to the equilibrator (60) rather than the cryogenic helium bath (72).

2. The apparatus (1) of claim 1, said airlock chamber (20) comprising a dynamic seal or baffle.

3. The apparatus (1) of any preceding claim, wherein the cooling unit (50) is a refrigeration unit, a stored liquid or solid cryogen cooling system, or a continuous flow cryostat.

4. The apparatus (1) of claim 3, wherein the cooling unit (50) has a thermal performance at temperatures less than 10 Kelvin and is connected to the equilibrator by a thermal refrigeration link (80).

5. The apparatus (1) of any preceding claim, wherein the sample path (10) further comprises first and second tubular structures (12,14) each having low thermal conductivity, said first and second tubular structures being geometrically offset such that there is no direct line of sight from an entrance of the first tubular structure (12) to an exit of the second tubular structure (14).

6. The apparatus (1) of claim 5, further comprising a funnel (32) positioned between the airlock chamber (20) and sample path (10), said funnel comprising a conical region in fluid communication with the airlock chamber and a narrowed region in fluid communication with the first tubular structure.

7. The apparatus (1) of any preceding claim, further comprises a positioning system (55) to control the position of the sample in the sample path (10).

8. The apparatus (1) of claim 7, wherein the positioning system (55) comprises a robotic system with feedback control to control the location of the sample within the sample path (10).

9. The apparatus (1) of any preceding claim further comprises a heat source (75) coupled to the cryogenic helium bath (72) to increase pressure within the sample path (10).

10. A method for introducing a sample into a cryogenic system (70) comprising:
loading the sample into an airlock chamber (20);
evacuating the airlock chamber (20);
inserting the sample from the airlock chamber (20) into a sample path (10);
lowering the sample into an equilibrator (60), said equilibrator located within the sample path (10);
conducting heat from the sample to a cooling unit (50) connected to the equilibrator (60) through a thermal linkage (80); and
inserting the sample from the equilibrator (60) into a lower section of the sample path (10) and into a cryogenic helium bath (72); **characterized in that**:
the lowering step comprising lowering the sample from the equilibrator (60) into the cryogenic helium bath (72) in successive steps wherein each step reduces the distance between the sample in the sample path (10) and the cryogenic helium bath (72), and wherein the lowering step further comprises retracting the sample into the equilibrator (60) after each successive step to allow for enhanced transfer of heat from the sample to the equilibrator (60) rather than the cryogenic helium bath (72).

## Patentansprüche

1. Vorrichtung (1) zum Einführen einer Probe in ein kryogenes System (70), Folgendes umfassend:
eine Luftschleusenkammer (20),
ein kryogenes Heliumbad (72) und
einen Probenweg (10), der sich zwischen einem ersten Ende, das in Fluidverbindung mit der Luftschleusenkammer steht, und einem zweiten Ende, das in Fluidverbindung mit dem kryogenen Heliumbad steht, erstreckt,
wobei der Probenweg (10) ferner Folgendes umfasst:
einen Equilibrator (60), der zwischen der Luftschleuse und dem kryogenen Heliumbad angebracht ist, wobei der Equilibrator es einer Probe ermöglicht, zu dem kryogenen Heliumbad zu gelangen und
einer Kältemaschine (50), die an den Equilibrator (60) gekoppelt ist, um die Temperatur des Equilibrators (60) zu steuern,
**dadurch gekennzeichnet, dass** die Vorrichtung (1) dazu angeordnet ist, die Probe von dem Equilibrator (60) in das Heliumbad (72) in aufeinanderfolgenden Schritten hinabzulassen, wobei jeder Schritt den Abstand zwischen der Probe in dem Probenweg (10) und dem kryogenen Heliumbad (72) verringert, und die Probe nach jedem aufeinanderfolgenden Schritt in den Equilibrator (60) zurückzuziehen, um eine verbesserte Übertragung der Wärme von der Probe auf den Equilibrator (60) statt in das kryogene Heliumbad (72) zu ermöglichen.

2. Vorrichtung (1) nach Anspruch 1, wobei die Luftschleusenkammer (20) eine dynamische Dichtung oder Zwischenwand umfasst.

3. Vorrichtung (1) nach einem vorhergehenden Anspruch, wobei die Kältemaschine (50) eine Kühleinheit, eine gespeicherte Flüssigkeit oder ein solides kryogenes Kühlsystem oder ein Durchflusskryostat ist.

4. Vorrichtung (1) nach Anspruch 3, wobei die Kältemaschine (50) bei Temperaturen von weniger als 10 Kelvin eine thermische Leistungsfähigkeit hat und durch eine thermische Kühlverbindung (80) mit dem Equilibrator verbunden ist.

5. Vorrichtung (1) nach einem vorhergehenden Anspruch, wobei der Probenweg (10) ferner erste und zweite Röhrenkonstruktionen (12, 14) umfasst, die jeweils eine geringe thermische Leitfähigkeit haben, wobei die ersten und zweiten Röhrenkonstruktionen geometrisch so versetzt sind, dass keine direkte Sichtlinie von einem Eingang der ersten Röhrenkonstruktion (12) zu einem Ausgang der zweiten Röhrenkonstruktion (14) besteht.

6. Vorrichtung (1) nach Anspruch 5, ferner einen Trichter (32) umfassend, der zwischen der Luftschleusenkammer (20) und dem Probenweg (10) angebracht ist, wobei der Trichter einen mit der Luftschleusenkammer in Fiuidverbindung stehenden konischen Bereich und einen mit der ersten Röhrenkonstruktion in Fluidverbindung stehenden sich verengenden Bereich umfasst.

7. Vorrichtung (1) nach einem vorhergehenden Anspruch, ferner umfassend ein Positionierungssystem (55) zum Steuern der Position der Probe in dem Probenweg (10).

8. Vorrichtung (1) nach Anspruch 7, wobei das Positionierungssystem (55) ein Robotersystem mit Regelung umfasst, um den Ort der Probe im Probenweg (10) zu steuern.

9. Vorrichtung (1) nach einem vorhergehenden Anspruch, ferner umfassend eine an das kryogene Heliumbad (72) gekoppelte Wärmequelle (75) zum Erhöhen des Drucks im Probenweg (10).

10. Verfahren zum Einführen einer Probe in ein kryogenes System (70), Folgendes umfassend:
Laden der Probe in eine Luftschleusenkammer (20),
Leeren der Luftschleusenkammer (20),
Einführen der Probe aus der Luftschleusenkammer (20) in einen Probenweg (10),
Hinablassen der Probe in einen Equilibrator (60), wobei sich der Equilibrator in dem Probenweg (10) befindet,
Leiten der Wärme von der Probe zu einer mit dem Equilibrator (60) verbundenen Kältemäschine (50) durch eine thermische Verbindung (80) und
Einführen der Probe aus dem Equilibrator (60) in einen weiter unten befindlichen Abschnitt des Probenwegs (10) und in ein kryogenes Heliumbad (72), **dadurch gekennzeichnet, dass**:
der Schritt des Hinablassens das Hinablassen der Probe von dem Equilibrator (60) in das kryogene Heliumbad (72) in aufeinanderfolgenden Schritten umfasst, wobei jeder Schritt den Abstand zwischen der Probe in dem Probenweg (10) und dem kryogenen Heliumbad (72) verringert und wobei der Schritt des Hinablassens ferner nach jedem aufeinanderfolgenden Schritt Zurückziehen der Probe in den Equilibrator (60) umfasst, um eine verbesserte Übertragung der Wärme von der Probe auf den Equilibrator (60) statt in das kryogenen Heliumbad (72) zu ermöglichen.

## Revendications

1. Appareil (1) pour introduire un échantillon dans un système cryogène (70) comprenant :
une chambre formant sas (20) ;
un bain d'hélium cryogène (72) ; et
un chemin d'échantillon (10) s'étendant entre une première extrémité reliée en communication à fluide à la chambre formant sas et une seconde extrémité reliée en communication à fluide au bain d'hélium cryogène ;
dans lequel le chemin d'échantillon (10) comprend en outre :
un équilibreur (60) positionné entre le sas et le bain d'hélium cryogène, l'équilibreur permettant le passage d'un échantillon jusqu'au bain d'hélium cryogène, et
une unité de refroidissement (50) couplée à l'équilibreur (60) pour commander la température de l'équilibreur (60) ;
**caractérisé en ce que** l'appareil (1) est agencé pour abaisser l'échantillon de l'équilibreur (60) dans le bain d'hélium (72) par étapes successives, dans lesquelles chaque étape réduit la distance entre l'échantillon dans le chemin d'échantillon (10) et le bain d'hélium cryogène (72), et pour rétracter l'échantillon dans l'équilibreur (60) après chaque étape successive pour permettre un transfert de chaleur amélioré de l'échantillon à l'équilibreur (60) plutôt qu'au bain d'hélium cryogène (72).

2. Appareil (1) selon la revendication 1, ladite chambre formant sas (20) comprenant un joint dynamique ou une chicane.

3. Appareil (1) selon l'une quelconque des revendications précédentes, dans lequel l'unité de refroidissement (50) est une unité de réfrigération, un système de refroidissement à cryogène solide ou à liquide stocké, ou un cryostat à flux continu.

4. Appareil (1) selon la revendication 3, dans lequel l'unité de refroidissement (50) a une performance thermique à des températures inférieures à 10 Kelvin et est reliée à l'équilibreur par une liaison de réfrigération thermique (80).

5. Appareil (1) selon l'une quelconque des revendications précédentes, dans lequel le chemin d'échantillon (10) comprend en outre des première et seconde structures tubulaires (12, 14) chacune ayant une faible conductibilité thermique, lesdites première et seconde structures tubulaires étant géométriquement décalées de sorte qu'il n'y a aucune ligne de vue directe d'une entrée de la première structure tubulaire (12) à une sortie de la seconde structure tubulaire (14).

6. Appareil (1) selon la revendication 5, comprenant en outre un entonnoir (32) positionné entre la chambre formant sas (20) et le chemin d'échantillon (10), ledit entonnoir comprenant une région conique en communication à fluide avec la chambre formant sas et une région rétrécie en communication à fluide avec la première structure tubulaire.

7. Appareil (1) selon l'une quelconque des revendications précédentes, comprenant en outre un système de positionnement (55) pour commander la position de l'échantillon dans le chemin d'échantillon (10).

8. Appareil (1) selon la revendication 7, dans lequel le système de positionnement (55) comprend un système robotisé avec asservissement pour commander l'emplacement de l'échantillon à l'intérieur du chemin d'échantillon (10).

9. Appareil (1) selon l'une quelconque des revendications précédentes, comprenant en outre une source de chaleur (75) couplée au bain d'hélium cryogène (72) pour augmenter la pression à l'intérieur du chemin d'échantillon (10).

10. Procédé pour introduire un échantillon dans un système cryogène (70) comprenant :
le chargement de l'échantillon dans une chambre formant sas (20) ;
la mise sous vide de la chambre formant sas (20) ;
l'insertion de l'échantillon depuis la chambre formant sas (20) dans un chemin d'échantillon (10) ;
l'abaissement de l'échantillon dans un équilibreur (60), ledit équilibreur étant situé à l'intérieur du chemin d'échantillon (10) ;
la conduction de chaleur depuis l'échantillon à une unité de refroidissement (50) reliée à l'équilibreur (60) par une liaison thermique (80) ; et
l'insertion de l'échantillon provenant de l'équilibreur (60) dans une section inférieure du chemin d'échantillon (10) et dans un bain d'hélium cryogène (72) ; **caractérisé en ce que** :
l'étape d'abaissement comprend l'abaissement de l'échantillon provenant de l'équilibreur (60) dans le bain d'hélium cryogène (72) par étapes successives, dans lesquelles chaque étape réduit la distance entre l'échantillon dans le chemin d'échantillon (10) et le bain d'hélium cryogène (72), et dans lequel l'étape d'abaissement comprend en outre la rétractation de l'échantillon dans l'équilibreur (60) après chaque étape successive pour permettre un transfert de chaleur amélioré de l'échantillon à l'équilibreur (60) plutôt qu'au bain d'hélium cryogène (72).
